Europäisches Patentamt

European Patent Office

Office européen des brevets

(11) Publication number: **0 443 400 A1**

# EUROPEAN PATENT APPLICATION

(21) Application number: 91101883.6

(22) Date of filing: 11.02.91

(51) Int. Cl.⁵: **C08K 9/04**, C08L 27/12

(30) Priority: 21.02.90 US 483502

(43) Date of publication of application:
28.08.91 Bulletin 91/35

(84) Designated Contracting States:
DE FR GB IT

(71) Applicant: ROGERS CORPORATION
Main Street
Rogers, Conn. 06263(US)

(72) Inventor: Arthur, David J.
31 Fales Avenue
Norwood, Massachusetts 02063(US)
Inventor: Swei, Swo S.
60 Valentine Road
Northboro, Massachusetts 01532(US)
Inventor: Nguyen, Phong X.
180 Allen Street, C2
New Britain, Connecticut 06053(US)

(74) Representative: Meyers, Ernest et al
Office de Brevets FREYLINGER & ASSOCIES
B.P. 1 321, route d'Arlon
L-8001 Strassen(LU)

(54) **Dielectric composite.**

(57) A composite material is disclosed. The material comprises a polymeric matrix and from about 20 volume percent to about 70 volume percent inorganic particles distributed throughout the matrix. Suitable inorganic particles include hollow inorganic microspheres and porous inorganic particles. The inorganic particles are coated with a surface coating. The composite material of the present invention exhibits a dielectric constant of less than about 2.5 and a thermal coefficient of expansion of less than about 70 ppm/° C.

DIELECTRIC CONSTANT AND Z-AXIS CTE PERFORMANCE COMPARISONS FOR COMMERCIALLY AVAILABLE DIELECTRIC MATERIALS

- PTFE
- RT/d 5870 (R)
- ULTRALAM tm
- RO2800
- POLYIMIDE/KEVLAR
- QUARTREX/QUARTZ
- EPOXY/KEVLAR
- POLYIMIDE/KEVLAR
- EPOXY/GLASS
- RT/d 6010.2
- ROGERS tm 3001 BOND FILM
- ALUMINA CERAMIC

Z-AXIS THERMAL COEFFICIENT OF EXPANSION (ppm/ C)

FIG. 1

## DIELECTRIC COMPOSITE

U.S. patent application, S.N. 015,191, filed February 17, 1987, describes a ceramic filled fluoropolymer matrix electrical substrate material sold by Rogers Corporation under the trademark RO-2800. This material preferably comprises a polyetrafluoroethylene matrix filled with amorphous fused silica and microfiberglass. The silica filler is coated with a silane coating material which renders the surface of the silica hydrophobic and provides improved tensile strength, peel strength and dimensional stability to the composite material. The electrical substrate material is well suited for forming a rigid printed wiring board substrate and exhibits improved electrical performance over other printed wiring board substrate materials.

Two properties are of particular interest with regard to the performance of an electrical printed wiring board substrate material. A low dielectric constant, i.e. (DK) DK ≤ about 3 is particularly desirable in such materials. The low DK significantly improves the electrical performance of PWB material by a reduction in propagation delay, cross-talk, and rise time degradation in digital and microwave PWB applications. It is also important that PWB substrate materials exhibit a low Z axis coefficient of thermal expansion, i.e. (CTE) CTE ≤ about 70 ppm/° C. An electrical substrate known as Rogers RO-2800 is described in U.S. Patent No. 4,849,284. The substrate comprises a fluoropolymer matrix and a silane-coated ceramic filler. The substrate exhibits a DK of about 2.8 and a Z-axis CTE of about 24 ppm/° C.

The purpose of the present invention is to provide a PWB substrate material which exhibits an advantageous balance of mechanical, thermal and electrical properties.

The composite material of the present invention comprises a fluoropolymer matrix, from about 20 volume % to about 70 volume % first coated inorganic particles distributed throughout the matrix. The first coated inorganic particles comprise hollow inorganic microspheres and a hydrophobic coating on the microspheres. The material exhibits a DK of less than about 2.5 and a Z-axis CTE of less than about 50.

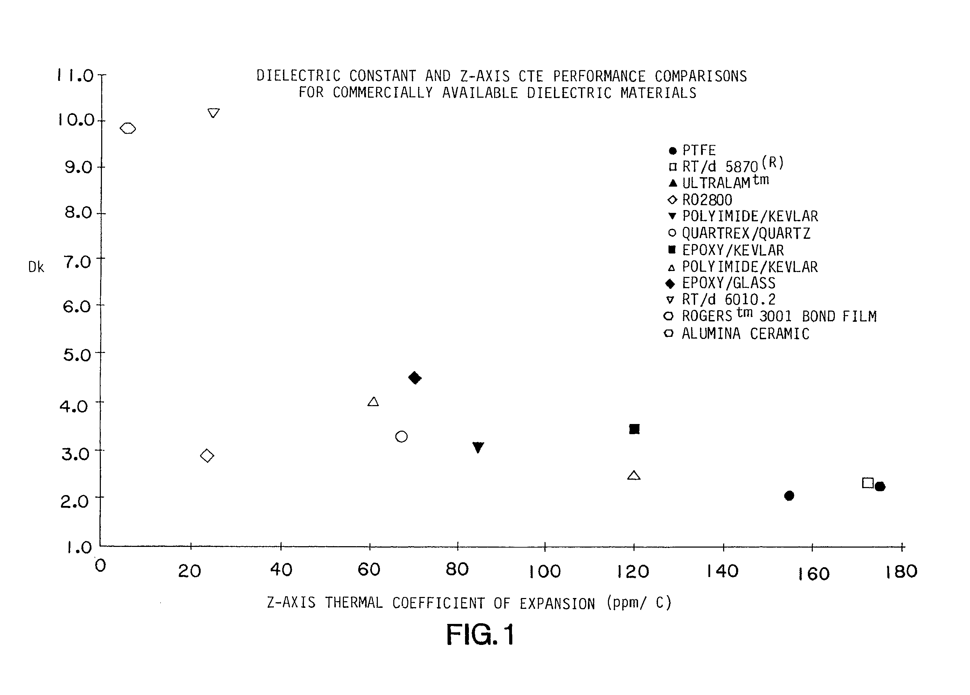

Figure 1 shows a comparison of dielectric constant and the Z axis CTE for a number of dielectric substrate materials.

The fluoropolymer matrix of the composite material of the present invention may comprise any fluoropolymer that exhibits a low dielectric constant. Polyetrafluoroethylene (PTFE), hexafluoropropene (HFP), tetrafluoropolyethylene (TFE), and perfluoroalkylvinyl ether (PAVE), are examples of suitable fluoropolymer matrix materials. PTFE is the preferred matrix material.

A PTFE powder known as Teflon[(R)]6C, available from DuPont, and a PTFE dispersion known as Fluon[(R)]AD704, available from ICI, have been found to be particularly well suited for use in the present invention.

The first inorganic particles of the present invention may comprise hollow inorganic microspheres and a hydrophobic coating on the microspheres. It is preferred that the first inorganic particles exhibit low ionic contamination.

Hollow inorganic microspheres having a density of less than about 1 gram/cubic centimeter (g/cm³) are preferred. For a given microsphere material, the theoretical dielectric constant of the microsphere decreases with decreasing density. It should be noted that since the microspheres become increasing fragile and susceptible to mechanical damage during processing with decreasing microsphere density, a balance between performance and processability must be determined, based on the particular application of the material of the present invention.

Hollow inorganic microspheres are available from a number of commercial sources. Hollow glass microspheres and hollow ceramic microspheres are suitable for use in the present invention. Silica microspheres and borosilicate microspheres are preferred. Hollow silica microspheres, known as SI Eccospheres and manufactured by Emerson & Cuming, Dewey & Almy Chemical Division of W.R. Grace & Co. of Canton, MA, hollow borosilicate microspheres, known as H-50/10,000 Glass Bubbles, manufactured by 3M Company of St. Paul, MN and, hollow high silica microspheres known as SDT-60 Eccospheres, also manufactured by Emerson & Cuming, have been found to be particularly suitable for use in the practice of the present invention. The SI Eccospheres are hollow silica microspheres having an average particle size of about 80 um and an average particle density ranging from about 0.14 g/cm³ to about 0.8 g/cm³. The H-50/10,000 are hollow borosilicate microspheres having an average particle density of about 0.5 g/cm³ to about 0.6 g/cm³ and are available in different particle size distributions. The SDT-60 Eccospheres are hollow high silica microspheres having an average particle density of 0.28 g/cm³ and particles ranging in size from about 5 um to about 40 um.

The first inorganic particles comprise between about 10 volume % and about 70 volume % of the composite material of the present invention. Preferably the first inorganic particles comprise between about 15 volume % and about 65 volume % of the composite material of the present invention. In applications in which low DK is of primary importance, it is preferred that the composition of the present invention comprises from about 35 volume percent to about 65 volume percent hollow inorganic microspheres.

The second inorganic particles of the present invention may comprise any particulate inorganic filler material that exhibits a low coefficient thermal expansion and low DK. It is preferred that the second inorganic particles exhibit low ionic contamination. The second inorganic particles may comprise porous second inorganic particles or nonporous second inorganic particles.

The porous inorganic particles of the present invention may be any porous inorganic particles having a dielectric constant of less than 3.5. It is preferred that the porous inorganic particles have void space greater than about 20 volume % and an internal surface area greater than about 150 $m^2/g$. It is preferred that the porous inorganic particles comprise porous silica particles. The preferred range of particle size of the porous inorganic particles is dependent upon the particular application of the composite material.

Glass particles, known as Corning VYCOR(R)7930, manufactured by Corning Glass Works, Corning, N.Y. have been found to be particularly well suited for use as the porous second inorganic particles of the present invention. VYCOR(R)7930 glass particles have a dielectric constant of about 3.0, a void space of about 28 volume %, a surface area of about 250 $m^2/g$, an average pore diameter of about 40 A and a specific gravity of about 1.5.

Suitable nonporous second inorganic particles include glass particles, ceramic particles, glass fibers and ceramic fibers. While continuous fibers may be suitable for use in some embodiments of the present invention, discontinuous fibers are preferred.

Silica particles are particularly preferred nonporous second inorganic particles and amorphous fused silica particles are most preferred nonporous second inorganic particles. It is preferred that the nonporous second inorganic particles of the present invention exhibit an average particle size about less than about 30 microns. Amorphous fused silica particles known as GP-7I, manufactured by Harbison-Walker were found to be particularly well suited for use as nonporous second inorganic particles of the present invention.

The second inorganic particles comprise up to about 55 volume % of the composite material of the present invention. The second inorganic particles preferably comprise less than about 40 % of the composite material of the present invention for application in which low DK is of primary importance.

The hydrophobic coating of the present invention may comprise any coating material that is thermally stable, exhibits a low surface energy, and improves the moisture resistance of the composite of the present invention. Suitable coating materials include conventional silane coatings, titanate coatings and zirconate coatings. Preferred silane coatings include : phenyltrimethoxysilane, phenyltriethoxysilane, (3,3,3-trifluropropyl) trimethoxysilane, (tridecafluoro-1,1,2,2-tetrahydrodecyl)-1,1 triethoxysilane, (heptadecafluoro-1,1,2,2-tetrahydrodecyl)-1-triethoxysilane and mixtures thereof. Suitable titanate coatings include : neopentyl(diallyl)-xytrineodecanoyl titanate, neopentyl(diallyl)oxytri-(dodecyl)benzene-sulfonyl titanate and neopentyl(diallyl)-oxytri(dioctyl)phosphate titanate. Suitable zirconate coatings include : neopentyl(diallyl)-oxytri(dioctyl)-pyrophosphate zirconate and neopentyl(diallyl)oxytri-(N-ethylenediamino)ethyl zirconate.

The hydrophobic coating is used in an amount effective to render the surfaces of the filler particles hydrophobic and compatible with the matrix material. The amount of coating relative to the amount of inorganic particles coated will vary with the surface area coated and density of the inorganic particles. Preferably, the coated inorganic particles of the present invention include from about 3 parts by weight (pbw) hydrophobic coating : 100 pbw inorganic particles to about 15 pbw hydrophobic coating : 100 pbw inorganic particles.

The filler materials are coated by agitating the filler materials in a solution of the coating material, removing the filler material from the solution and finally heating the filler material to evaporate solvents from the coating and to react the coating with the surface of the filler material.

The composite material of the present invention is compounded by the procedure outlined in U.S. Patent 4,355,180, the disclosure of which is incorporated by reference. Briefly, the process includes mixing silane coated inorganic particles with a fluoropolymer dispersion, coagulating the mixture using a flocculating agent, filtering the coagulated mixture and then consolidating the mixture to form a composite substrate at elevated temperature (315 °C to 425 °C) and pressure ($7.10^5$ PA to $62.10^5$ PA). Alternatively, a fluoropolymer powder may be mixed with the coated filler particles and the mixture so formed may be consolidated under elevated temperature and pressure to form the composite substrate. It should be noted that consolidation pressures must be limited to pressures below the compressive strength of the microspheres to avoid excessive breakage of the microspheres.

## EXAMPLE

Samples of the composite material of the present invention were prepared.

A hydrolyzed silane coating solution was made by dissolving 3 wt % of (tridecafluoro-1,1,2,2 tetrahydrooctyl)-1,1-triethoxysilane in isopropanol. The solution was diluted with water to produce a solution having water to silane stoichiometric ratio of 3 to 1. The pH of the solution was adjusted to 5 with acetic acid. The solution was then stirred for 24 hours.

The inorganic particles were coated with the silane coating solution. The particles were immersed in the solution and agitated in a Patterson-Kelly mixer for 40 minutes. The mixture was stored for 8 hours in a closed container. The particles were removed from the solution and dried at 120 °C to evaporate the solvents from the mixture and to cure the silane coating onto the surfaces of the particles.

The particles were combined with a fluoropolymer matrix to make sample composite materials. The coated filler particles were mixed with fluoropolymer particles (Teflon[(R)]6C) and a lubricant (dipropylene glycol) to form a paste. The paste was extruded and calendered at room temperature to form sheets. The sheets were hot pressed at 370 °C and $34.5.10^5$ PA to consolidate the composite material.

The above procedure was repeated to produce samples of different compositions. The composition of each of the samples by volume fraction is given in Table 1.

## TABLE 1

|  | A | B | C | D | E | F | G | H |
|---|---|---|---|---|---|---|---|---|
| FLUOROPOLYMER MATRIX | | | | | | | | |
| PTFE | 40 | 40 | 40 | 40 | 40 | 40 | 40 | 40 |
| FIRST INORGANIC PARTICLES | | | | | | | | |
| silica microspheres[2] | 60 | -- | -- | -- | -- | 50 | -- | -- |
| borosilicate microspheres[3] | -- | 60 | -- | -- | -- | -- | 30 | -- |
| borosilicate microspheres[4] | -- | -- | 60 | -- | -- | -- | -- | 40 |
| silica microspheres[5] | -- | -- | -- | 30 | 30 | -- | -- | -- |
| SECOND INORGANIC PARTICLES | | | | | | | | |
| porous silica particles[6] | -- | -- | -- | -- | -- | -- | -- | 20 |
| amorphous fused silica[7] | -- | -- | -- | 30 | 30 | 10 | 30 | -- |
| HYDROPHOBIC COATING | | | | | | | | |
| silane coupling agent[8] | + | + | + | + | -/+[9] | + | + | + |

1. Teflon 6C, DuPont

2. SDT-60, Emerson & Cuming
3. H-50/10,000 (325 Mesh), 3M
4. H-50/10,000 (500 Mesh), 3M
5. SI Eccospheres, Emerson & Cuming
6. Vycor 7930, Corning Glass Works
7. GP-7l, Harbison-Walker
8. (Tridecafluoro-1,1,2,2-tetrahydrooctyl)-1,1-triethoxysilane
9. Coupling agent on second particles only

The DK and CTE and water absorption of the composite materials so produced were measured and are set out in Table 2 below.

## TABLE 2

| | A | B | C | D | E | F | G | H |
|---|---|---|---|---|---|---|---|---|
| Dielectric Constant | 1.938 | 1.943 | 2.029 | 2.42 | 2.38 | 2.109 | 2.31 | 2.20 |
| CTE (ppm/°C) | 47 | 50 | 41 | 29 | 29 | 33 | 20 | 32 |
| Water Absorption | $2.84_1$ | $1.73_2$ | $1.91_1$ | $0.56_1$ | $0.68_1$ | -- | $2.85_1$ | $1.80_2$ |

$1 = 48$ hours, $50\ °C$
$2 = 24$ hours, $50\ °C$

Comparison of samples A, B, and C shows the effect of different choices of first inorganic particles. Comparison of samples A, F, G and H shows the effect of introducing second inorganic particles. Comparison of the water absorption results of samples D and E demonstrates the benefit of using the coupling agent of the present invention.

The DK and Z axis CTE for a number of conventional dielectric substrate materials are presented in Figure 1 for comparison with the values tabulated in Table 2. None of the conventional substrate materials exhibit a DK of less than about 2.5 and a z-axis CTE of less than about 50.

**Claims**

1. A composite material , comprising : a fluoropolymer matrix ; from about 20 volume percent to about 70 volume percent first coated inorganic particles distributed throughout the matrix, said first coated inorganic particles comprising : hollow inorganic microspheres and a hydrophobic coating on the microspheres.

2. A composite material as claimed in claim 1, wherein the composite material exhibits a dielectric constant of less than about 2.5 and a thermal coefficient of expansion of less than about 70 ppm/°C.

3. A composite material as claimed in claim 1, wherein the matrix comprises polytetrafluoroethylene, hexafluoropropene tetrafluoroethylene, or perfluoroalkylvinyl ether.

4. A composite material as claimed in claim 1, wherein the hollow inorganic microspheres comprise glass microspheres or ceramic microspheres.

5. A composite material as claimed in claim 4, wherein the glass microspheres comprise high silica glass or borosilicate glass.

6. A composite material as claimed in claim 1, wherein the hydrophobic coating is selected from the group consisting of silane coatings, zirconate coatings and titanate coatings.

7. A composite material as claimed in claim 6, wherein the first coated inorganic particles comprises between about 3 parts by weight coating : 100 parts by weight microspheres and about 15 parts by weight coating : 100 parts by weight microspheres.

8. A composite material as claimed in claim 6, wherein the coating comprises phenyltrimethoxysilane, phenyltriethoxysilane, (3,3,3-trifluoropropyl) trimethoxysilane, (tridecafluoro-1,1,2,2 tetrahydrooctyl) 1,1 triethoxysilane, (heptadecafluoro-1,1,2,2-tetrahydrodecyl)-1-triethoxysilane and mixtures thereof.

9. A composite material as claimed in claim 6, wherein the coating comprises neopentyl(diallyl)-oxytrineodecanoyl titanate, neopentyl(diallyl)oxytri(dodecyl)benzene-sulfonyl titanate and neopentyl-(diallyl)oxytri(dioctyl)phosphate titanate.

10. A composite material as claimed in claim 6, wherein the coating comprises neopentyl(diallyl)oxytri-(dioctyl)-pyrophosphate zirconate and neopentyl(diallyl)oxytri-(N-ethylenediamino)ethyl zirconate.

11. A composite material as claimed in claim 1, further comprising :
    up to about 35 volume percent of second coated inorganic particles distributed throughout the matrix, provided that the combined amount of the first and second coated inorganic particles does not exceed 70 volume percent, said second coated inorganic particles comprising inorganic particles chosen from the group consisting of porous inorganic particles, solid inorganic particles and mixtures thereof and hydrophobic coating on the inorganic particles.

12. A composite material as claimed in claim 11, wherein the second coated inorganic particles comprise porous inorganic particles having a void space greater than about 20 volume % and an external surface area greater than about 150 $m^2/g$.

13. A composite material as claimed in claim 12, wherein the porous inorganic particles comprises porous glass particles or porous ceramic particles.

14. A composite material as claimed in claim 13, wherein the porous glass particles comprise a high silica glass.

15. A composite material as claimed in claim 11, wherein the second inorganic particles comprise nonporous inorganic particles.

16. A composite material as claimed in claim 15, wherein the second inorganic particles comprise amorphous fused silica particles.

DIELECTRIC CONSTANT AND Z-AXIS CTE PERFORMANCE COMPARISONS
FOR COMMERCIALLY AVAILABLE DIELECTRIC MATERIALS

Legend:
- ● PTFE
- ⊡ RT/d 5870 (R)
- ▲ ULTRALAM tm
- ◇ RO2800
- ▼ POLYIMIDE/KEVLAR
- ○ QUARTREX/QUARTZ
- ■ EPOXY/KEVLAR
- △ POLYIMIDE/KEVLAR
- ◆ EPOXY/GLASS
- ▽ RT/d 6010.2
- ○ ROGERS tm 3001 BOND FILM
- ⊡ ALUMINA CERAMIC

Dk (y-axis)

Z-AXIS THERMAL COEFFICIENT OF EXPANSION (ppm/ C)

FIG. 1

EP 0 443 400 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | WPIL, FILE SUPPLIER, accession no. 90-207228 [27], Derwent Publications Ltd, London, GB; <br> & JP-A-2 140 256 (JUNKOSHA) 29-05-1990 <br> * Abstract * <br> — — — | 1 | C 08 K 9/04 <br> C 08 L 27/12 |
| A,D | EP-A-0 279 769  (ROGERS CORP.) <br> * Claim 1 * <br> — — — — — | 1 | |

| | |
|---|---|
| | TECHNICAL FIELDS SEARCHED (Int. Cl.5) |
| | C 08 K <br> C 08 L |

The present search report has been drawn up for all claims

| Place of search | Date of completion of search | Examiner |
|---|---|---|
| The Hague | 10 April 91 | ENGEL H.S.L. |

CATEGORY OF CITED DOCUMENTS

X : particularly relevant if taken alone
Y : particularly relevant if combined with another
document of the same catagory
A : technological background
O : non-written disclosure
P : intermediate document
T : theory or principle underlying the invention

E : earlier patent document, but published on, or after
the filing date
D : document cited in the application
L : document cited for other reasons

 

& : member of the same patent family, corresponding
document